# EUROPÄISCHE PATENTSCHRIFT

(11) **EP 3 982 131 B1**
(45) Veröffentlichungstag und Bekanntmachung des Hinweises auf die Patenterteilung: **11.09.2024**
(21) Anmeldenummer: 21201657.0
(22) Anmeldetag: 08.10.2021
(51) Int. Cl.: G01R 31/08, G01R 19/25, H04B 3/46, H02J 13/00

(54) **SYSTEM ZUR KOMBINIERTEN ORTS-, ZEIT- UND FREQUENZABHÄNGIGEN BESTIMMUNG ELEKTRISCHER KENNGRÖSSEN IN EINEM ENERGIEVERSORGUNGSNETZ**
SYSTEM FOR THE COMBINED LOCATION, TIME AND FREQUENCY-DEPENDENT DETERMINATION OF ELECTRICAL PARAMETERS IN A POWER SUPPLY NETWORK
SYSTÈME DE DÉTERMINATION, AVEC UNE DÉPENDANCE COMBINÉE DE L'EMPLACEMENT, DU TEMPS ET DE LA FRÉQUENCE, DES GRANDEURS ÉLECTRIQUES DANS UN RÉSEAU D'ALIMENTATION ÉLECTRIQUE

(30) Priorität: 08.10.2020 EP 20200834
(43) Veröffentlichungstag der Anmeldung: 13.04.2022
(73) Patentinhaber: Helmut-Schmidt-Universität, 22043 Hamburg (DE)
(72) Erfinder: SCHULZ, Detlef, 22043 Hamburg (DE)
(74) Vertreter: Kröncke, Rolf

(56) Entgegenhaltungen:
- EP-A1- 3 336 995
- EP-A1- 3 540 911
- WO-A1-2008/019634
- WO-A1-2015/168260
- WO-A2-2016/174476
- AU-B1- 2019 284 127
- CN-A- 108 512 904
- DE-A1- 102016 002 267
- MEYER M ET AL: "Frequency response measurements on railway traction units", EB - ELEKTRISCHE BAHNEN, vol. 105, no. 10, 1 October 2007 (2007-10-01), DE, pages 521 - 527, XP055778815, ISSN: 0013-5437
- DASH K ET AL: "FAST ESTIMATION OF VOLTAGE AND CURRENT PHASORS IN POWER NETWORKS USING AN ADAPTIVE NEURAL NETWORK", IEEE TRANSACTIONS ON POWER SYSTEMS, IEEE SERVICE CENTER, PISCATAWAY, NJ, US, vol. 12, no. 4, 1 November 1997 (1997-11-01), pages 1494 - 1499, XP011050561, ISSN: 0885-8950

## Beschreibung

Die Erfindung betrifft ein System zur kombinierten orts-, zeit- und frequenzabhängigen Bestimmung elektrischer Kenngrößen in einem Energieversorgungsnetz. In elektrischen Systemen treten häufig Überlagerungen der orts-, zeit- und frequenzabhängigen elektrischen Kenngrößen auf, die zu Störungen z.B. an Netzbetriebsmitteln und Verbrauchern sowie zu Störungen im Netzbetrieb führen. Hierbei werden die Instabilitäten des Netzbetriebs durch Resonanzen verursacht, die durch den Betrieb von Netzstromrichtern entstehen können. Dies führt zu einer Verminderung der Spannungsqualität bis hin zu Netzinstabilitäten und Netzausfällen, denen keine klar definierte Ursache zugeordnet werden kann.

Typische Anwendungsfelder, in denen solche Störungen an Netzbetriebsmitteln und Verbrauchern sowie Störungen im Netzbetrieb auftreten, sind z.B.:
- Antriebe oder Generatoren mit Frequenzumrichtern, z. B. drehzahlgeregelte Antriebe in Produktionsanlagen, Verladeeinrichtungen wie Förderbändern, Kränen; Windpark-Installationen
- Elektrische Bahnnetze für den Personen- und Gütertransport
- Lokale Bahnnetze, wie U-Bahn, S-Bahn, Straßenbahn, Oberleitungsbusnetze
- Elektrische Fernverkehrstrassen, wie Oberleitungsnetze für Lkw
- Elektrische Bordnetze in Kraftfahrzeugen, Schiffen/U-Booten und Flugzeugen

Folgende Quelle adressiert solche Netzausfälle im schweizerischen Bahnnetz: Markus Meyer, Wettingen; Martin Aeberhard, Zollikofen; Kaspar Germann, Bern; Rolf Suter, Thun; Peter Dahler, Turgi: Messung des Frequenzgangs von Triebfahrzeugen, eb 105 (2007) Heft 10, S. 521-527.

Störungen an Netzbetriebsmitteln und Verbrauchern versucht man bisher durch die getrennte Überwachung von zeitabhängigen elektrischen Kenngrößen wie Spannung und Strom sowie durch die davon unabhängige Überwachung von frequenzabhängigen elektrischen Kenngrößen wie Spanungs- und stromharmonischen sowie davon abgeleiteten Abschaltgrenzwerten zu verhindern.

Aus der DE 10 2016 002 267 A1 ist eine Anordnung und ein Verfahren zur Messung der elektrischen Eigenschaften am Anschlusspunkt eines elektrischen Energieversorgungsnetzes, von daran angeschlossenen Erzeugern, Verbrauchern oder Teilnetzen bekannt. Aus der WO 2015/168260 A1 ist ein smartes Sensornetzwerk für die lokale Zustandsüberwachung in einem Energieversorgungsnetz bekannt. Aus der EP 3 336 995 A1 ist ein Verfahren, eine Steuereinrichtung und ein System zum Ermitteln von Zustandswerten zur Beschreibung von Betriebszuständen in einem Teilnetz eines Energieversorgungsnetzes bekannt.

Der Erfindung liegt die Aufgabe zugrunde, ein System anzugeben, mit dem solche Störungen in Energieversorgungsnetz noch besser identifiziert und vermieden werden können.

Diese Aufgabe wird durch ein System gemäß Anspruch 1 gelöst. Vorteilhafte Ausführungsformen sind in den Unteransprüchen beschrieben.
a) Das System weist ein Anregesystem auf, das dazu eingerichtet ist, willkürlich wenigstens ein elektrisches Anregesignal in das Energieversorgungsnetz einzuspeisen,
b) das System weist ein Messsystem auf, das dazu eingerichtet ist, infolge des elektrischen Anregesignals auftretende elektrische Kenngrößen in dem Energieversorgungsnetz orts-, zeit- und frequenzabhängig zu bestimmen,
c) wobei das Messsystem eine Sensorik aufweist, die eine Vielzahl örtlich über das Energieversorgungsnetz verteilter Sensoren und/oder ortsvariable Sensoren hat, anhand derer elektrische Kenngrößen in dem Energieversorgungsnetz an unterschiedlichen Orten und dementsprechend ortsabhängig bestimmbar sind.

Mit einem solchen System können auf einfache und kostengünstige Weise folgende, bisher ungelöste Probleme gelöst werden:
- Bisher nicht erfasste ortsabhängig wirkende elektrische Kenngrößen erzeugen zusätzliche Störpotenziale, die zu unerwünschten Abschaltungen führen, z.B. die seit langem bekannte Ausbreitung von Wanderwellen in 110-kV-Hoch- und 220-bzw. 380-kV-Höchstspannungsnetzen.
- Das Anfahren und Abbremsen von elektrischen Triebfahrzeugen von elektrischen Bahnen im Bahn-, S-Bahn-, U-Bahn- und Straßenbahnbetrieb erzeugt ortsabhängige Anfahr- und Abbremsströme, deren Wirkung mit den bisherigen Mess- und Auswertemethoden nicht online kalkulierbar ist.
- Dies gilt auf allen Spannungsebenen, d.h. der Niederspannung bis 1 kV, der Mittelspannung bis 52 kV, der Hochspannung bis 150 kV mit genormten Spannungswerten von 110 kV, der Höchstspannung oberhalb von 150 kV mit genormten Spannungswerten von 220 kV und 380 kV und der Ultra-Höchstspannung mit Spannungswerten oberhalb von 500 kV
- Dies gilt auf allen Spannungsebenen sowohl für 50-Hz- und 60-Hz-Wechsel- und Drehstromnetze, als auch für 16 2/3-Hz Wechselstromnetze sowie Gleichspannungsnetze von elektrischen Bahnen und auch Hochspannungs-Gleichstromnetze
- Dadurch werden die Störpotenziale heute nicht so weit klassifizierbar, dass selektiv, d.h. lokal gut eingegrenzt, gegen sie geschützt werden kann.
- Dadurch kommt es zu Ausfällen von elektrischen Bahnen.
- Dadurch kommt es zu Netzabschaltungen im Bereich der 110-kV-Hoch- und 220-bzw. 380-kV-Höchstspannungsnetze.
- Dadurch kommt es zu Netzabschaltungen im Bereich der Hochspannungs-Gleichstromnetze.
- Aufgrund fehlender kombinierter orts-, zeit- und frequenzabhängiger online-Identifikation elektrischer Netze lässt sich insbesondere im Bereich der elektrischen Bahnnetze nicht zuverlässig zwischen dem zulässigen Normalbetrieb und dem Fehlerbetrieb unterscheiden.
- Aufgrund fehlender Verfahren zur kombinierten orts-, zeit- und frequenzabhängigen online-Identifikation elektrischer Netze lassen sich keine praxisrelevanten Tests elektrischer Betriebsmittel, Komponenten und Anlagen definieren.

Beim erfindungsgemäßen System wird daher zusätzlich eine ortsabhängige Komponente der Bestimmung der elektrischen Kenngrößen in dem Energieversorgungsnetz vorgeschlagen. Dies gelingt dadurch, dass das Messsystem eine Sensorik hat, die eine Vielzahl örtlich über das Energieversorgungsnetz verteilter Sensoren, die z.B. ortsfest angeordnet sein können, und/oder ortsvariable Sensoren hat. Die ortsvariablen Sensoren können entweder willkürlich an einem bestimmten, gewünschten Ort gesteuert werden oder befinden sich z.B. an einem Verkehrsmittel, das sich entlang des Energieversorgungsnetzes bewegt.

Es sollen die kombinierten orts-, zeit- und frequenzabhängigen Eigenschaften elektrischer Systeme bestimmt werden. Diese sind für die Funktion elektrischer Betriebsmittel und angeschlossener Verbraucher bestimmend. Als elektrisches System wird hier eine Einzelkomponente oder die Gesamtheit der Netzbetriebsmittel, wie Kabel, Leitungen, Transformatoren, Kompensationsanlagen inklusive der an das Netz angeschlossenen elektrischen Verbraucher und elektrischen Erzeuger definiert. Ausführung der Einrichtung: Vorrichtung zum Anschluss an elektrische Verbraucher (nimmt elektrische Energie auf) und Erzeuger (gibt elektrische Energie ab) bzw. kombinierte Verbraucher/Erzeuger, sog. Prosumer, die zeitweise als Verbraucher und zeitweise als Erzeuger arbeiten.

Es wird z.B. eine stationär fest verbaute, stationäre "mitfahrende" (fest verbaut und mitfahrend) oder instationär bewegliche (örtlich veränderliche) Sensorik zur Erfassung der Ortsabhängigkeit genutzt. Die zeit- und frequenzabhängigen Kenngrößen elektrischer Systeme werden z.B. durch eine entlang der elektrischen Leitungen bewegte Sensorik zusätzlich ortsabhängig gemessen und mit den zeit- und frequenzabhängigen Kenngrößen verknüpft. Dies erfolgt z.B. durch:
1. Eine fest verbaute "mitfahrende" Sensorik, die sich z.B. in elektrisch mit dem Netz gekoppelten Fahrzeugen, z.B. in elektrischen Bahnfahrzeugen innerhalb des elektrischen Systems bewegt. Die Bestimmung der Messgrößen kann dabei passiv oder aktiv erfolgen. Es handelt sich um ein örtlich bewegliches Messen, z.B. durch klassische Sensoren oder Messgeräte, von orts-, zeit- und frequenzabhängigen elektrischen Kenngrößen
2. Örtlich bewegliches Messen durch mobile Sensoren, wie z.B. mobilen Hochspannungselektroden zur Messung von Spannungen an Freileitungen, von zeit- und frequenzabhängigen elektrischen Kenngrößen
3. Bewegung von Spannungs- und Stromsensoren entlang von elektrischen Systemen, z. B. entlang von Freileitungen, mit mechanisch geführten (z.B. an Rollen an Leiterseilen aufgehängten) oder mechanisch ungeführten (z.B. Drohnen) Verfahreinrichtungen zur Erfassung von orts-, zeit- und frequenzabhängigen elektrischen Kenngrößen

Gemäß einer vorteilhaften Ausgestaltung der Erfindung ist vorgesehen, dass das Anregesystem eine Aktorik aufweist, die eine Vielzahl örtlich über das Energieversorgungsnetz verteilter Aktoren und/oder ortsvariable Aktoren hat, anhand derer elektrische definierte synchrone oder asynchrone Anregesignale mit definierten Pulsmustern in das Energieversorgungsnetz an unterschiedlichen Orten einspeisbar sind. Dies hat den Vorteil, dass die Anregesignale nach Wunsch an unterschiedlichen Orten in das Energieversorgungsnetz eingespeist werden können. Die Aktoren können dabei jeweils an einem gemeinsamen Ort mit einem oder mehreren Sensoren angeordnet sein, oder an anderen Orten als die Sensoren. Ortsvariable Aktoren können mit ortsvariablen Sensoren jeweils örtlich zusammengefasst sein, sodass für die Änderung des Einsatzortes des Sensors und des Aktors nur ein gemeinsamer Antrieb erforderlich ist.

Als solche Anregesignale eignen sich Spannungen oder Ströme oder Impedanzen sowie mögliche Kombinationen daraus, die auf das Energieversorgungsnetz geschaltet werden. Solche Anregesignale können in Pulsmustern mit einer festen oder variablen Einschalt- und Pausenzeiten geschaltet werden. Pulsmuster sind zeitlich definierte Zuschaltungen von Spannungs- und/oder Stromsignalen und/oder elektrischen Impedanzen mit beliebigen Frequenzen von 0 Hz (Gleichgröße) bis zu Frequenzen im MHz-Bereich als periodische oder Einmal-Größe (Impuls). Das zeitlich definierte Zuschalten erfolgt mit einer festen oder variablen Einschalt- und Pausenzeit. Synchrone Anregesignale haben zeitlich gemeinsame Nulldurchgänge mit der Grundfrequenz des zu messenden Energieversorgungsnetzes. Asynchrone Anregesignale haben keine zeitlich gemeinsamen Nulldurchgänge mit der Grundfrequenz des zu messenden Energieversorgungsnetzes.

Gemäß der Erfindung ist vorgesehen, dass das System ein Auswertesystem aufweist, das zur Auswertung der orts-, zeit- und frequenzabhängig bestimmten elektrischen Kenngrößen des Energieversorgungsnetzes und zur Erzeugung einer wenigstens örtlich und zeitlich aufgelösten Darstellung der elektrischen Kenngrößen oder daraus bestimmter elektrischer Systemantworten des Energieversorgungsnetzes eingerichtet ist. Dies erlaubt eine schnelle und zuverlässige Diagnose der eingangs erwähnten Netzstörungen.

Gemäß der Erfindung ist vorgesehen, dass das Auswertesystem zur Erzeugung einer, mehrerer oder aller der nachfolgenden Darstellungen der elektrischen Kenngrö-ßen oder daraus bestimmter elektrischer Systemantworten des Energieversorgungsnetzes eingerichtet ist:
a) Darstellung des Orts über die Zeit und die elektrischen Größen,
b) Darstellung der Zeit über den Ort und die elektrischen Größen,
c) Darstellung der elektrischen Größen über den Ort und die Zeit.

Dabei kann das Auswertesystem vorteilhaft zur Erzeugung der jeweiligen Darstellung mittels einer Echtzeit-Online-Berechnung von aus den zeit-, orts- und frequenzabhängigen Kenngrößen abgeleiteten Größen eingerichtet sein.

Gemäß Merkmal a) wird eine Landkarte der Zeit- und elektrischen Größen erstellt. Gemäß Merkmal b) wird eine Zeitkarte der Orts- und elektrischen Größen erstellt. Gemäß Merkmal c) wird eine Elektro-Zeit-Karte der elektrischen Größen für unterschiedliche Zeiten und Orte erstellt. Hierdurch werden die Diagnosemöglichkeiten bei Netzstörungen erheblich erweitert und verbessert.

Gemäß einer vorteilhaften Ausgestaltung der Erfindung ist vorgesehen, dass das System dazu eingerichtet ist, kontinuierlich im realen Betrieb des Energieversorgungsnetzes über das Anregesystem elektrische Anregesignale in das Energieversorgungsnetz einzuspeisen und über das Messsystem infolge der auftretende elektrische Kenngrößen in dem Energieversorgungsnetz orts-, zeit- und frequenzabhängig zu bestimmen. Das System erlaubt somit eine online-Identifikation von Netzstörungen zu jeder Zeit, auch im Echtzeit-Betrieb.

Gemäß einer vorteilhaften Ausgestaltung der Erfindung ist vorgesehen, dass das Messsystem dazu eingerichtet ist, die orts-, zeit- und frequenzabhängig bestimmten elektrischen Kenngrößen des Energieversorgungsnetzes und/oder daraus abgeleitete mathematisch bestimmbare Kenngrößen zeitsynchron zu speichern. Dies hat den Vorteil, dass eine Vielzahl von über das Messsystem bestimmten Kenngrößen gespeichert werden kann, die nachfolgend miteinander zeitlich synchron beispielsweise statistisch ausgewertet werden können.

Gemäß einer vorteilhaften Ausgestaltung der Erfindung ist vorgesehen, dass das Anregesystem dazu eingerichtet ist, elektrische Anregesignal zu Anregezeitpunkten in das Energieversorgungsnetz einzuspeisen, die voneinander gleichmäßig oder ungleichmäßig beabstandet sind, oder mit einer Kombination aus gleichmäßig und ungleichmäßig beabstandeten Anregezeitpunkten. Hierdurch werden die Diagnosemöglichkeiten bei Netzstörungen erheblich erweitert und verbessert.

Dies erlaubt z.B. die Realisierung von synchron-sub-asynchronen Anrege- und Messverfahren für die kombinierte orts-, zeit- und frequenzabhängige online-Identifikation elektrischer Systeme. So kann das betreffende elektrische System durch die Anregesignale zeitlich synchron-sub-asynchron angeregt werden. Zeitlich synchron bedeutet, dass die Zeitabstände zwischen den Anregezeitpunkten bzw. zwischen den Messzeitpunkten immer zeitlich konstant sind. Zeitlich asynchron bedeutet, dass die Zeitabstände variabel sind. Zeitlich synchron-sub-asynchron bedeutet, dass neben zeitlich konstanten (synchronen) Anregungen und Messungen noch zeitlich variable Anregungen und Messungen erfolgen.

Dies kann bei aktiven Verfahren z.B. durch Anregung des Systems und Messung wie folgt durchgeführt werden:
I. mit einer zeitlich konstanten (gleiche Abstände zwischen den Anregesignalen) oder zeitlich variablen (ungleiche Abstände zwischen den Anregesignalen) zeitlich synchronen (in allen Leitern gleichzeitigen) Anregung von Mehrleitersystemen
II. zeitlich parallel dazu erfolgt eine zeitlich konstante oder variable Einzelanregung der Phasenleiter, diese Einzelanregung kann mit den Signalen aus II synchron oder asynchron erfolgen
III. Einleitersysteme können zeitlich konstant oder zeitlich variabel synchron oder asynchron angeregt/gemessen werden

Gemäß einer vorteilhaften Ausgestaltung der Erfindung ist vorgesehen, dass das Messsystem dazu eingerichtet ist, zusätzliche elektrische Kenngrößen in dem Energieversorgungsnetz orts-, zeit- und frequenzabhängig auch ohne Einspeisung von elektrischen Anregesignalen zu bestimmen. Auf diese Weise unterstützt das System auch passive Messverfahren. Hierdurch können weitere Informationen über das Energieversorgungsnetz gewonnen werden, sodass sie Diagnose von Netzstörungen weiter verbessert wird.

Somit können sowohl passive als auch aktive Messverfahren genutzt werden. Definition passive Messverfahren: Verfahren, die ausschließlich in elektrischen Systemen bereits ohne aktive Anregung vorhandene Messgrößen erfassen, d.h. passiv messen, z.B. Spannung/Strom/Frequenz, Spannungs-/Stromharmonische, Frequenzabweichungen.

Definition aktive Messverfahren: Verfahren, die ein elektrisches System aktiv durch Anregesignale anregen (z.B. durch zuschalten einer elektrischen last oder eines elektrischen Verbrauchers), damit eine "Reaktion" des Systems darauf erzeugen (z.B. einen Spannungseinbruch) und die Reaktion auf die Anregung messen.

Zur vollständigen Identifikation von Kenngrößen elektrischer Systeme ist es vorteilhaft, deren orts-, zeit- und frequenzabhängiges Verhalten zu erfassen. Dies soll erreicht werden durch eine voneinander abhängige Kombination von folgenden Kenngrößen:
1. ortsabhängige Ermittlung elektrischer Kenngrößen
2. zeitabhängige Ermittlung elektrischer Kenngrößen
3. frequenzabhängige Ermittlung elektrischer Kenngrößen
4. die Ort (auch: Weg)-Zeit-Messgrößen-Synchronisation, d.h. die Zuordnung der Messwerte zu Zeit- und Ortskoordinaten

Die gemeinsam oder getrennt ausgeführten Sensoren für orts-, zeit- und frequenzabhängige Messgrößen liefern Ausgangssignale, die zeitlich synchron pro Messzyklus erfasst werden.

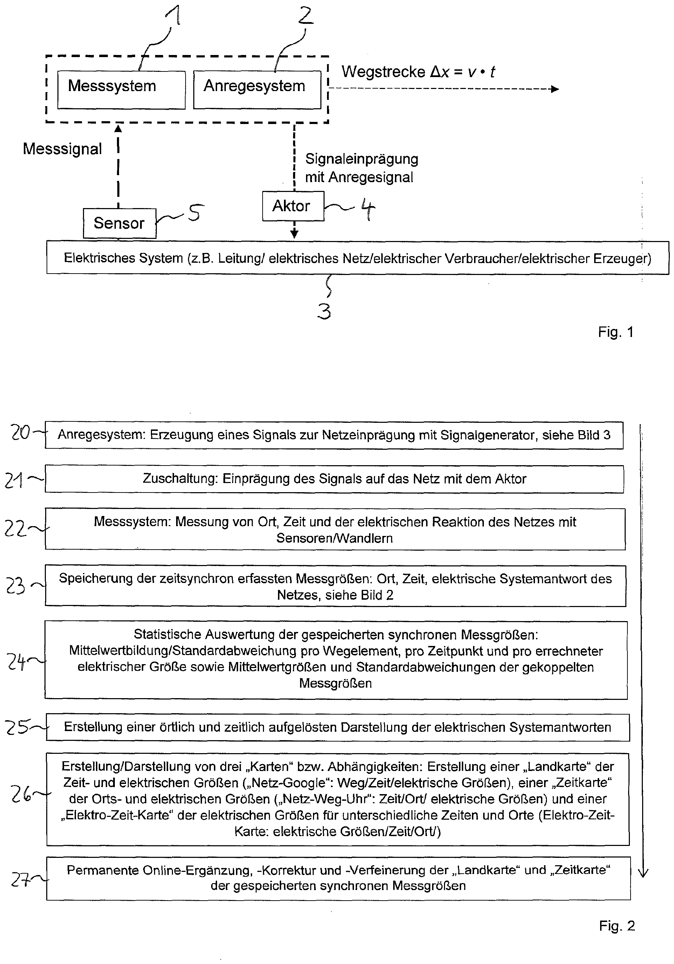

Die Figur 1 zeigt in schematischer Darstellung ein erfindungsgemäßes System zur kombinierten orts-, zeit- und frequenzabhängigen Bestimmung elektrischer Kenngrö-ßen in einem Energieversorgungsnetz 3. Das System weist ein Messsystem 2 und ein Anregesystem 1 auf. Das Messystem 2 nimmt über Messensoren 5, z.B. Messwandler, die orts-, zeit- und frequenzabhängigen Messgrößen auf. Das Anregesystem 1 regt das elektrische System 3 an und erzeugt damit eine Reaktion, z.B. die Veränderung der Spannungsamplitude. Im dargestellten Beispiel sind sowohl das Anregesystem 1 als auch das Messsystem 2 auf einem mobilen Träger angeordnet, der ortsvariabel ist, d. h. der relativ zum elektrischen System 3 bewegt werden kann.

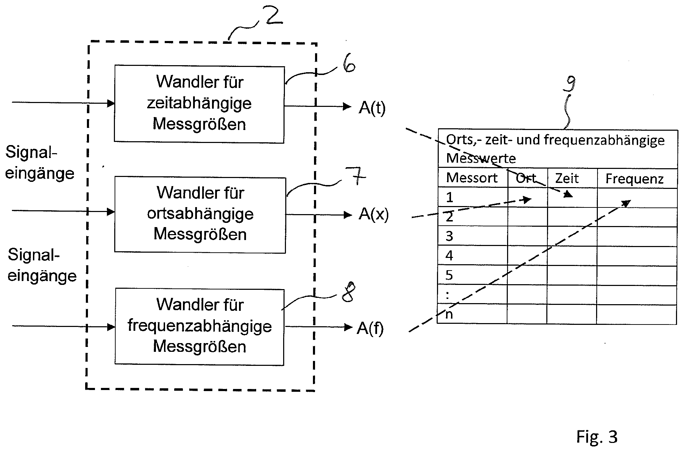

Die Figur 2 zeigt beispielhaft den Ablauf bei der Einspeisung von Anregesignalen in das Energieversorgungsnetz und der Erfassung der auftretenden elektrischen Kenngrößen in dem Energieversorgungsnetz über das Messsystem 2. Gemäß Block 20 wird durch das Anregesystem 1 mit einem Signalgenerator ein Anregesignal erzeugt, das in das Energieversorgungsnetz 3 eingeprägt werden soll. Gemäß Block 21 erfolgt daraufhin die physische Einprägung des Anregesignals in das Energieversorgungsnetz 3 durch einen Aktor. Das eingeprägte Anregesignal erzeugt in der Regel eine Veränderung einer oder mehrerer elektrischer Kenngrößen im Energieversorgungsnetz 3. In einem Block 22 erfolgt daraufhin eine Messung von Ort, Zeit und der elektrischen Reaktion des Energieversorgungsnetzes 3 mit Sensoren bzw. Wandlern des Messsystems 2. In einem Block 23 erfolgt eine Speicherung der zeitsynchron im Block 22 erfassten Messgrößen, nämlich Ort, Zeit und elektrische Systemantwort des Energieversorgungsnetzes 3, wie in Figur 3 dargestellt.

Nach Speicherung einer Vielzahl solcher aufgenommenen Messgrößen, d. h. nach mehrfachem Durchlaufen der Blöcke 20 bis 23, insbesondere an verschiedenen Orten des Energieversorgungsnetzes 3, kann im Block 24 eine statistische Auswertung der gespeicherten zeitsynchronen Messgrößen durchgeführt werden, z.B. einem Mittelwertbildung und Berechnung der Standardabweichung pro Wegelement, pro Zeitpunkt und pro errechneter elektrischer Größe sowie von Mittelwertgrößen und Standardabweichungen der gekoppelten Messgrößen. Danach kann im Block 25 die Erstellung einer örtlich und zeitlich aufgelösten Darstellung der elektrischen Systemantworten durchgeführt werden. Es kann insbesondere, wie im Block 26 dargestellt, die Erstellung bzw. Darstellung von drei "Karten" bzw. Abhängigkeiten durchgeführt werden: Erstellung einer "Landkarte" der Zeit- und elektrischen Größen ("Netz-Google": Weg/Zeit/elektrische Größen), einer "Zeitkarte" der Orts- und elektrischen Größen ("Netz-Weg-Uhr": Zeit/Ort/ elektrische Größen) und einer "Elektro-Zeit-Karte" der elektrischen Größen für unterschiedliche Zeiten und Orte (Elektro-Zeit-Karte: elektrische Größen/Zeit/Ort/).

Zusätzlich kann gemäß Block 27 eine permanente Online-Ergänzung, -Korrektur und -Verfeinerung der "Landkarte" und "Zeitkarte" der gespeicherten synchronen Messgrößen durchgeführt werden, d.h. eine laufende Aktualisierung der Darstellungen, indem der Verfahrensablauf immer wieder erneut durchlaufen wird.

Die Figur 3 zeigt schematisch die zeitsynchrone Aufnahme der Messwerte im Messsystem 2 sowie die zeitsynchrone Speicherung, z.B. nach Art einer Tabelle 9. Das Messsystem 2 kann dabei einen Wandler 6 für zeitabhängige Messgrößen, einen Wandler 7 für ortsabhängige Messgrößen einen Wandler 8 für frequenzabhängige Messgrößen aufweisen.

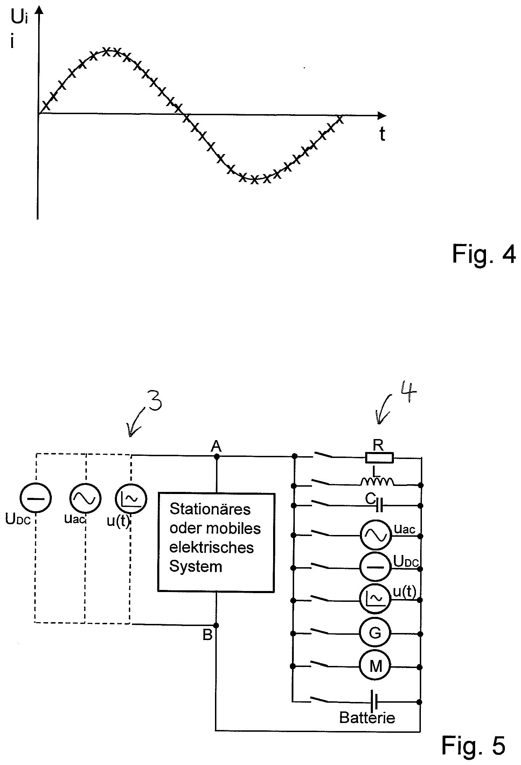

Die Erfindung kann mit einem zeitschrittweisen Anrege- und Messverfahren für die kombinierte orts-, zeit- und frequenzabhängige online-Identifikation elektrischer Systeme erweitert werden. Die Figur 4 zeigt die zeitschrittweise Anregung jedes gewünschten Punktes auf der Spannungs- bzw. Stromkurve. Das zu analysierende elektrische System soll in einstellbaren Zeitschritten kontinuierlich oder auch nur punktweise als Abtastreihe oder Einzelpunkt der Messgrößen-Zeitkurve angeregt werden. In Figur 4 ist das anhand eines Beispiels für eine Spannungs- bzw. Strom-Zeit-Kurve gezeigt. Dies gilt für alle der zu messenden Kenngrößen, die rein physikalische, aber auch daraus mathematisch errechnete Kenngrößen sein können.

Die Figur 5 zeigt zumindest einen Teil des Anregesystems 1, insbesondere eine Ausführungsform von dessen Aktoren 4. Bei aktiven Messverfahren, d.h. Messverfahren, die ein elektrisches System aktiv anregen und die Reaktion auf die Anregung messen, soll ein Anregesystem für beliebige elektrische Systeme genutzt werden. Das Anregesystem kann für beliebige stationäre oder mobile elektrische Systeme genutzt werden. Die beliebigen stationären oder mobilen elektrischen Systeme können Bestandteil eines elektrischen Gesamtsystems sein.

Das Anregesystem 1 gemäß Figur 5 arbeitet mit der Zuschaltung passiver linearer oder nichtlinearer Bauelemente, mit aktiven Quellen oder Bauelementen oder mit beliebigen Kombinationen daraus, z.B. durch die Zuschaltung von:
a) Ohmscher Widerstand
b) Induktivität
c) Kapazität
d) Elektrische Energiespeicher in Form von Batterien, Akkus
e) Rotierende elektrische Energiewandler in Form von Motoren oder Generatoren
f) Beliebig einstellbarer Gegenspannung mit vom Messobjekt abweichender Phasenlage bzw. Phasenfolge (insbesondere unter- bzw. oberhalb einer Spannung eines aktiven Messobjekts)
g) Beliebig einstellbarer Mitspannung mit der Phasenlage bzw. Phasenfolge des Messobjekts (insbesondere unter- bzw. oberhalb einer Spannung eines aktiven Messobjekts)

Das Anregesystem 1 gemäß Figur 5 arbeitet auch mit beliebigen Mischformen der Zuschaltung von a) bis g) in der Form eines Verbrauchers oder Erzeugers.

Mit dem genutzten Messverfahren wird unter Nutzung der Zuschaltung von a) bis g) die Reaktion des elektrischen Systems auf die erfolgte Anregung gemessen.

Es werden orts-, zeit- und frequenzabhängige elektrische Kenngrößen erfasst. Eine Kenngröße kann eine physikalische (Mess-) Größe, aber auch eine daraus mathematisch errechnete (Rechen-) Größe sein.
A. Zeitabhängige elektrische Kenngrößen Kt sind:
   a) direkte zeitanhängige Kenngrößen wie Spannung, Strom, Frequenz
   b) kalkulierte zeitabhängige Größenprodukte wie Wirk-, Blind- und Scheinleistung
   c) kalkulierte zeitabhängige Differenzgrößen für Zeitdifferenzen, z.B. t2-t1, wie Spannungsdifferenz, Spannungsanstieg und -abfall (du/dt), Stromdifferenz, Stromanstieg und -abfall (di/dt), Frequenzdifferenz, Frequenzanstieg und -abfall (df/dt), Leistungsdifferenz, Leistungsanstieg und -abfall (dP/dt),
      Systemimpedanzdifferenz, Netzimpedanzanstieg und -abfall (dZ/dt)
   d) Flussrichtungen des Stromes und der Leistungen
   e) Zeitliche Änderungen von spektralen Größen, d.h. Zeit-Frequenzabhängigkeiten Die Sensorik für zeitabhängige elektrische Kenngrößen liefert Messwerte x =f(Kt ,t)
B. Frequenzabhängige elektrische Kenngrößen K_{f} sind:
   a) direkte zeitabhängige Kenngrößen wie Spannung, Strom, Frequenz
   b) kalkulierte zeitabhängige Größenprodukte wie Wirk-, Blind- und Scheinleistung
   c) kalkulierte zeitabhängige Differenzgrößen für Zeitdifferenzen, z.B. t2-t1, wie Spannungsdifferenz, Spannungsanstieg und -abfall (du/dt), Stromdifferenz, Stromanstieg und -abfall (di/dt), Frequenzdifferenz, Frequenzanstieg und -abfall (df/dt), Leistungsdifferenz, Leistungsanstieg und -abfall (dP/dt), Netzimpedanzdifferenz, Netzimpedanzanstieg und -abfall (dZ/dt)
   d) Flussrichtungen des Stromes und der Leistungen
   e) Spektrale Darstellungen der frequenzabhängigen elektrischen Kenngrößen a) bis d), d.h. online-Spektralanalysen der Kenngrößen a) bis d)
   Die Sensorik für frequenzabhängige elektrische Kenngrößen liefert Messwerte x =f(Kf,f)
C. Ortsabhängige elektrische Kenngrößen Kₒ sind:
   - alle unter A. und B. genannten Größen mit zusätzlicher örticher Zuordnung
D. Weg-Zeit-Synchronisation
   Die Sensorik für ortsabhängige elektrische Kenngrößen liefert Messwerte x =f(Kₒ,f)
   Weg- Zeit-Synchronisation: Start bei Bezugspunkt x₀(t₀), Δx = x₀+x(t₀+t), dann Δx = v·t
E. Ermittlung von Differenz-Kenngrößen
   Z.B. Differenzweg-Impedanzermittlung, Dynamische Differenzweg-Impedanzermittlung im Frequenzbereich, Dynamische Störungsrichtungs-Ermittlung für Überspannungen und Überströme, Dynamische Differenzweg-Spektralgrößen

## Patentansprüche

1. System zur kombinierten orts-, zeit- und frequenzabhängigen Bestimmung elektrischer Kenngrößen in einem Energieversorgungsnetz (3) mit folgenden Merkmalen:
a) Das System weist ein Anregesystem (1) auf, das dazu eingerichtet ist, willkürlich wenigstens ein elektrisches Anregesignal in das Energieversorgungsnetz (3) einzuspeisen,
b) das System weist ein Messsystem (2) auf, das dazu eingerichtet ist, infolge des elektrischen Anregesignals auftretende elektrische Kenngrößen in dem Energieversorgungsnetz (3) orts-, zeit- und frequenzabhängig zu bestimmen,
c) wobei das Messsystem eine Sensorik (5) aufweist, die eine Vielzahl örtlich über das Energieversorgungsnetz verteilter Sensoren und/oder ortsvariable Sensoren hat, anhand derer elektrische Kenngrößen in dem Energieversorgungsnetz (3) an unterschiedlichen Orten und dementsprechend ortsabhängig bestimmbar sind,
wobei das System ein Auswertesystem aufweist, das zur Auswertung der orts-, zeit- und frequenzabhängig bestimmten elektrischen Kenngrößen des Energieversorgungsnetzes (3) und zur Erzeugung einer wenigstens örtlich und zeitlich aufgelösten Darstellung der elektrischen Kenngrößen oder daraus bestimmter elektrischer Systemantworten des Energieversorgungsnetzes (3) eingerichtet ist, **dadurch gekennzeichnet, dass** das Auswertesystem zur Erzeugung aller nachfolgenden Darstellungen der elektrischen Kenngrößen oder daraus bestimmter elektrischer Systemantworten des Energieversorgungsnetzes (3) eingerichtet ist:
d) Darstellung des Orts über die Zeit und die elektrischen Größen, indem eine Landkarte der Zeit- und elektrischen Größen erstellt wird,
e) Darstellung der Zeit über den Ort und die elektrischen Größen, indem eine Zeitkarte der Orts- und elektrischen Größen erstellt wird,
f) Darstellung der elektrischen Größen über den Ort und die Zeit, indem eine Elektro-Zeit-Karte der elektrischen Größen für unterschiedliche Zeiten und Orte erstellt wird.

2. System nach Anspruch 1, **dadurch gekennzeichnet dass** das Auswertesystem zur Identifizierung von Störpotentialen im Energieversorgungsnetz (3) aus der Kombination der orts-, zeit- und frequenzabhängig bestimmten elektrischen Kenngrößen des Energieversorgungsnetzes (3) eingerichtet ist.

3. System nach Anspruch 1 oder 2, **dadurch gekennzeichnet, dass** das Anregesystem (1) eine Aktorik (4) aufweist, die eine Vielzahl örtlich über das Energieversorgungsnetz (3) verteilter Aktoren und/oder ortsvariable Aktoren hat, anhand derer definierte zeitlich synchrone oder asynchrone elektrische Anregesignale mit definierten Pulsmustern in das Energieversorgungsnetz (3) an unterschiedlichen Orten einspeisbar sind.

4. System nach Anspruch 1 oder 2, **dadurch gekennzeichnet, dass** das Auswertesystem zur Erzeugung der jeweiligen Darstellung mittels einer Echtzeit-Online-Berechnung von aus den zeit-, orts- und frequenzabhängigen Kenngrößen abgeleiteten Größen eingerichtet ist.

5. System nach einem der vorhergehenden Ansprüche, **dadurch gekennzeichnet, dass** das System dazu eingerichtet ist, kontinuierlich im realen Betrieb des Energieversorgungsnetzes (3) über das Anregesystem (1) elektrische Anregesignale in das Energieversorgungsnetz (3) einzuspeisen und über das Messsystem (2) infolge der auftretende elektrische Kenngrößen in dem Energieversorgungsnetz (3) orts-, zeit- und frequenzabhängig zu bestimmen.

6. System nach einem der vorhergehenden Ansprüche, **dadurch gekennzeichnet, dass** das Messsystem (2) dazu eingerichtet ist, die orts-, zeit- und frequenzabhängig bestimmten elektrischen Kenngrößen des Energieversorgungsnetzes (3) und/oder daraus abgeleitete mathematisch bestimmbare Kenngrößen zeitsynchron zu speichern.

7. System nach einem der vorhergehenden Ansprüche, **dadurch gekennzeichnet, dass** das Anregesystem (1) dazu eingerichtet ist, elektrische Anregesignal zu Anregezeitpunkten in das Energieversorgungsnetz (3) einzuspeisen, die voneinander gleichmäßig oder ungleichmäßig beabstandet sind, oder mit einer Kombination aus gleichmäßig und ungleichmäßig beabstandeten Anregezeitpunkten.

8. System nach einem der vorhergehenden Ansprüche, **dadurch gekennzeichnet, dass** das Messsystem (2) dazu eingerichtet ist, zusätzliche elektrische Kenngrößen in dem Energieversorgungsnetz (3) orts-, zeit- und frequenzabhängig auch ohne Einspeisung von elektrischen Anregesignalen zu bestimmen.

## Claims

1. System for the combined location-, time- and frequency-dependent determination of electrical parameters in a power supply network (3) with the following features:
a) The system has an excitation system (1) which is set up to arbitrarily feed at least one electrical excitation signal into the power supply network (3),
b) the system has a measuring system (2) which is set up to determine electrical parameters occurring in the power supply network (3) as a result of the electrical excitation signal as a function of location, time and frequency,
c) wherein the measuring system has a sensor system (5) which has a plurality of sensors distributed locally over the power supply network and/or location-variable sensors, by means of which electrical parameters in the power supply network (3) can be determined at different locations and accordingly in a location-dependent manner,
the system having an evaluation system which is set up to evaluate the electrical characteristic variables of the power supply network (3), which are determined as a function of location, time and frequency, and to generate an at least spatially and temporally resolved representation of the electrical characteristic variables or electrical system responses of the power supply network (3) determined therefrom, **characterized in that** the evaluation system is set up to generate all subsequent representations of the electrical characteristic variables or electrical system responses of the power supply network (3) determined therefrom:
d) Representation of location over time and electrical quantities by creating a land map of time and electrical quantities,
e) Representation of time via the location and the electrical variables by creating a time map of the location and electrical variables,
f) Representation of electrical quantities over time and place by creating an electro-time map of electrical quantities for different times and places.

2. System according to claim 1, **characterized in that** the evaluation system is set up to identify interference potentials in the power supply network (3) from the combination of the location-, time- and frequency-dependent electrical parameters of the power supply network (3).

3. System according to claim 1 or 2, **characterized in that** the excitation system (1) has an actuator system (4) which has a plurality of actuators distributed locally over the power supply network (3) and/or location-variable actuators, by means of which defined temporally synchronous or asynchronous electrical excitation signals with defined pulse patterns can be fed into the power supply network (3) at different locations.

4. System according to claim 1 or 2, **characterized in that** the evaluation system is set up to generate the respective representation by means of a real-time online calculation of variables derived from the time-, location- and frequency-dependent parameters.

5. System according to one of the preceding claims, **characterized in that** the system is set up to continuously feed electrical excitation signals into the power supply network (3) via the excitation system (1) during real operation of the power supply network (3) and to determine electrical parameters occurring in the power supply network (3) as a result of the excitation signals in a location-dependent, time-dependent and frequency-dependent manner via the measuring system (2).

6. System according to one of the preceding claims, **characterized in that** the measuring system (2) is set up to store the location-, time- and frequency-dependent electrical parameters of the power supply network (3) and/or mathematically determinable parameters derived therefrom in a time-synchronous manner.

7. System according to one of the preceding claims, **characterized in that** the excitation system (1) is set up to feed electrical excitation signals into the power supply network (3) at excitation times which are evenly or unevenly spaced apart from one another, or with a combination of evenly and unevenly spaced excitation times.

8. System according to one of the preceding claims, **characterized in that** the measuring system (2) is set up to determine additional electrical parameters in the power supply network (3) as a function of location, time and frequency, even without feeding in electrical excitation signals.

## Revendications

1. Système de détermination combinée, en fonction de l'emplacement, du temps et de la fréquence, de grandeurs caractéristiques électriques dans un réseau d'alimentation en énergie (3), comprenant les éléments suivants :
a) le système présente un système d'excitation (1) conçu pour injecter arbitrairement au moins un signal d'excitation électrique dans le réseau d'alimentation en énergie (3),
b) le système présente un système de mesure (2) conçu pour déterminer, en fonction de l'emplacement, du temps et de la fréquence, des grandeurs caractéristiques électriques apparaissant dans le réseau d'alimentation en énergie (3) à la suite du signal d'excitation électrique,
c) le système de mesure présentant un système de capteurs (5) qui possède une pluralité de capteurs répartis localement sur le réseau d'alimentation en énergie et/ou des capteurs variables en fonction de l'emplacement, à l'aide desquels des grandeurs caractéristiques électriques peuvent être déterminées dans le réseau d'alimentation en énergie (3) à différents emplacements et donc en fonction de l'emplacement,
le système comprenant un système d'évaluation conçu pour évaluer les grandeurs caractéristiques électriques du réseau d'alimentation en énergie (3) déterminées en fonction de l'emplacement, du temps et de la fréquence, et pour produire une représentation au moins à résolution spatiale et temporelle des grandeurs caractéristiques électriques ou des réponses de système électriques du réseau d'alimentation en énergie (3) déterminées à partir de celles-ci,
**caractérisé en ce que**
le système d'évaluation est conçu pour produire toutes les représentations suivantes des grandeurs caractéristiques électriques ou des réponses de système électriques du réseau d'alimentation en énergie (3) déterminées à partir de celles-ci par :
d) la représentation de l'emplacement en fonction du temps et des grandeurs électriques, en établissant une carte géographique des grandeurs temporelles et électriques,
e) la représentation du temps en fonction de l'emplacement et des grandeurs électriques, en établissant une carte temporelle des grandeurs locales et électriques,
f) la représentation des grandeurs électriques en fonction de l'emplacement et du temps, en établissant une carte électrique/temporelle des grandeurs électriques pour différents temps et emplacements.

2. Système selon la revendication 1,
**caractérisé en ce que** le système d'évaluation est conçu pour identifier les potentiels de perturbation dans le réseau d'alimentation en énergie (3) à partir de la combinaison des grandeurs caractéristiques électriques du réseau d'alimentation en énergie (3) déterminées en fonction de l'emplacement, du temps et de la fréquence.

3. Système selon la revendication 1 ou 2,
**caractérisé en ce que** le système d'excitation (1) présente un système d'actionneurs (4) qui possède une pluralité d'actionneurs répartis localement sur le réseau d'alimentation en énergie (3) et/ou des actionneurs variables en fonction de l'emplacement, à l'aide desquels des signaux d'excitation électriques définis, synchrones ou asynchrones dans le temps, avec des modèles d'impulsions définis, peuvent être injectés dans le réseau d'alimentation en énergie (3) à différents emplacements.

4. Système selon la revendication 1 ou 2,
**caractérisé en ce que** le système d'évaluation est conçu pour produire la représentation respective au moyen d'un calcul en ligne en temps réel de grandeurs dérivées des grandeurs caractéristiques dépendant du temps, de l'emplacement et de la fréquence.

5. Système selon l'une des revendications précédentes,
**caractérisé en ce que** le système est conçu pour injecter en continu, en fonctionnement réel du réseau d'alimentation en énergie (3), des signaux électriques d'excitation dans le réseau d'alimentation en énergie (3) par l'intermédiaire du système d'excitation (1), et pour déterminer en fonction de l'emplacement, du temps et de la fréquence, par l'intermédiaire du système de mesure (2), des grandeurs caractéristiques électriques apparaissant dans le réseau d'alimentation en énergie (3).

6. Système selon l'une des revendications précédentes,
**caractérisé en ce que** le système de mesure (2) est conçu pour mémoriser de façon synchrone dans le temps les grandeurs caractéristiques électriques du réseau d'alimentation en énergie (3) déterminées en fonction de l'emplacement, du temps et de la fréquence et/ou les grandeurs caractéristiques déterminables mathématiquement qui en découlent.

7. Système selon l'une des revendications précédentes,
**caractérisé en ce que** le système d'excitation (1) est conçu pour injecter des signaux électriques d'excitation dans le réseau d'alimentation en énergie (3) à des instants d'excitation espacés de manière régulière ou irrégulière, ou avec une combinaison d'instants d'excitation espacés de manière régulière et irrégulière.

8. Système selon l'une des revendications précédentes,
**caractérisé en ce que** le système de mesure (2) est conçu pour déterminer des grandeurs caractéristiques électriques supplémentaires dans le réseau d'alimentation en énergie (3) en fonction de l'emplacement, du temps et de la fréquence, même sans injection de signaux d'excitation électriques.
